# EUROPEAN PATENT SPECIFICATION

(11) **EP 2 518 395 B1**
(45) Date of publication and mention of the grant of the patent: **03.08.2016**
(21) Application number: 12164292.0
(22) Date of filing: 16.04.2012
(51) Int. Cl.: F21V 5/04, F21V 5/00, F21Y 103/00, F21V 3/04

(54) **Light emitting device and illumination device using the same**
Lichtemittierende Vorrichtung und Beleuchtungsvorrichtung damit
Dispositif électroluminescent et dispositif d'éclairage l'utilisant

(30) Priority: 28.04.2011 JP 2011101170
(43) Date of publication of application: 31.10.2012
(73) Proprietor: Panasonic Intellectual Property Management Co., Ltd., Osaka 540-6207 (JP)
(72) Inventor: Yokotani, Ryoji, Hirakata, Osaka (JP); Kiba, Keiji, Osaka 540-6207 (JP)
(74) Representative: Rüger, Barthelt & Abel

(56) References cited:
- JP-A- 2006 054 396
- KR-B1- 100 986 468
- US-A1- 2008 076 198
- US-A1- 2009 296 388
- US-A1- 2010 177 532
- US-A1- 2010 265 693
- US-A1- 2011 073 899

## Description

### [Field of the Invention]

The present invention relates to a light emitting device using a plurality of solid-state light emitting elements as a light source and an illumination device using the same.

### [Background Art]

A light emitting diode (hereinafter referred to as an LED) is paid attention as a light source for illumination device, which replaces an incandescent light or a fluorescent light, because it can emit high luminance light with low power and has a longer life. However, an LED single body has a low light amount as compared with the fluorescent light, and.therefore in a typical illumination device using an LED as a light source, a light emitting device provided with a plurality of LEDs is used.

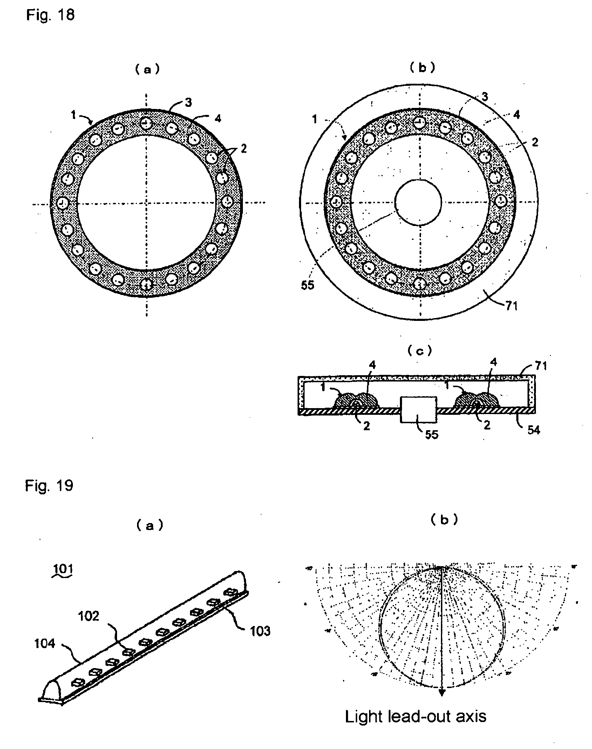

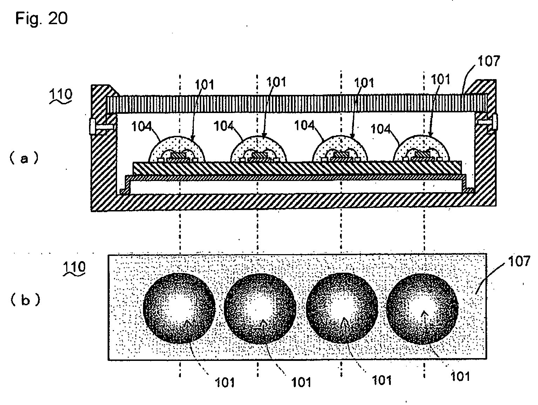

As this sort of light emitting device, as illustrated in Fig. 19 (a), there is known a light emitting device 101 in which on a long-sized board 103, a plurality of LEDs 102 are assembled in line, and a semicylindrically shaped transparent resin part 104 is provided so as to cover a whole of the LEDs 102 (see, for example, JPA 2002-299697). Also, as illustrated in Fig. 20 (a), there is known an illumination device 110 in which a plurality of LED packages 101 each having a hemispherical transparent resin part 104 are arranged, and in front of the LED packages 101, a diffusion transmission panel 107 is closely placed.

KR 100 986468 B1 shows a light emitting device comprising: a plurality of solid-state light emitting elements; a board that is assembled with the solid-state light emitting elements in an array; and a light distribution adjusting member that adjusts light distribution of light emitted from the solid-state light emitting elements. The light distribution adjusting member is provided with being shared by at least two or more solid-state light emitting elements among the solid-state light emitting elements arranged in an array. The light distribution adjusting member comprises: a containing part that contains the solid-state light emitting elements; a concavely curved surface part that is provided above light lead-out surfaces of the solid-state light emitting elements and also immediately above the solid-state light emitting elements; and a pair of convexly curved surface part that are provided on both sides of the concavely curved surface part and smoothly continuous with the concavely curved surface part in terms of surface.

US 2009/0296388 A1 discloses a light emitting device with LEDs covered by a light distribution adjusting member having a concave portion above the LEDs an two convex portions at opposite sides of the concave portion.

A similar light distribution adjusting member having a concave portion above the LEDs an two convex portions at opposite sides of the concave portion is shown in US 2010/0265693 A1.

Another known light emitting device is disclosed in US 2010/0177532 A1. A row of LEDs is covered by a light distribution adjusting member habing a triangular slot above the row of LEDs.

### [Disclosure of the Invention]

### [Problems to be solved by the Invention]

However, in the light emitting device 101 disclosed in JPA 2002-299697 , light exiting from each of the LEDs 102 through the semicylindrically shaped transparent resin part 104 travels straight or is refracted in an immediately upward direction of the LED 102, and is then condensed. For this reason, in the above light emitting device 101, as illustrated in Fig. 19 (b), light distribution of emitted light has high directionality in a light lead-out direction. Accordingly, in an illumination device using such a light emitting device, luminance in parts immediately above the LEDs 102 is high, and even if a light diffusing cover or the like is provided, luminance distribution on a light exit surface is nonuniform, and glare is likely to occur.

Also, in the above-described illumination device 110, luminance in positions on the diffusion transmission panel 107, which are just above the LED packages 101, is increased. As a result, as illustrated in Fig. 20 (b), luminance distribution on the light emitting surface (diffusion transmission panel 107) of the illumination device becomes nonuniform, which may give rise to a sense of grains due to the light source, and further cause glare.

The present invention is one that solves the above problems, and has an object to provide a light emitting device that can broaden light distribution of exit light and is unlikely to give rise to light unevenness, and an illumination device using the light emitting device.

### [Means adapted to solve the Problems]

In order to solve the above problems, the invention provides a device according to claim 1.

Preferably, the above light emitting device is further provided with a diffusion transmission cover member that covers the light distribution adjusting member.

In the above light emitting device, preferably, a light lead-out surface of the light distribution adjusting member is a rough surface.

In the above light emitting device the light lead-out surfaces of the solid-state light emitting elements are covered by a transparent resin.

In the above light emitting device, preferably, between the solid-state light emitting elements and an inner surface of the containing part, an air layer intervenes.

Preferably, the containing part is formed such that a gradient of a cross-sectional shape orthogonal to a longer direction of the containing part decreases toward any of light lead-out axes that respectively pass through central parts of the solid-state light emitting elements.

In the above light emitting device, preferably, a light exit surface of the light distribution adjusting member is provided with a plurality of convex lenses in a longer direction.

In the above light emitting device, preferably, a light exit surface of the light distribution adjusting member is provided with a plurality of concave lenses in a longer direction.

In the above light emitting device the transparent resin is configured as a wavelength converting member with containing a phosphor.

In the above light emitting device the wavelength converting member is formed so as to have, in a vertical cross-sectional view orthogonal to a longer direction of the light distribution adjusting member, an upward thickness that is thicker than a thickness in a lateral direction of the solid-state light emitting elements.

In the above light emitting device the wavelength converting member is formed in a vertically-long convex shape in the vertical cross-sectional view orthogonal to the longer direction of the light distribution adjusting member.

In the above light emitting device, preferably, the wavelength converting member is formed in a vertically-long triangular shape in the vertical cross-sectional view orthogonal to the longer direction of the light distribution adjusting member.

In the above light emitting device, preferably, the wavelength converting member is, in a top view, formed in a circular shape.

In the above light emitting device, preferably, the wavelength converting member is formed in an elliptical shape along the longer direction of the light distribution adjusting member in a top view.

In the above light emitting device, preferably, the wavelength converting member is formed by coating a phosphor-containing resin on the transparent resin or attaching a phosphor sheet to the transparent resin.

In the above light emitting device, preferably, the plurality of solid-state light emitting elements are linearly arranged; and the light distribution adjusting member is linearly configured.

In the above light emitting device, preferably, the plurality of solid-state light emitting elements are annularly arranged; and the light distribution adjusting member is annularly formed.

Preferably, the above light emitting device is used for an illumination device.

### [Effects of the Invention]

According to the light emitting device of the present invention, most of light entering the containing part of the light distribution adjusting member from the solid-state light emitting elements is fully reflected by the concavely curved surface part to travel in lateral directions, and is refracted by and transmits through the concavely curved surface part to thereby exit from the light distribution adjusting member with exhibiting broad light distribution. Also, directionality is reduced, and therefore when the light emitting device is used for an illumination device, light unevenness can be made difficult to occur.

### [Brief Description of the Drawings]

[Fig. 1] Fig. 1 is a side cross-sectional view along a longer direction of a light emitting device according to a conventional embodiment.
[Fig. 2] Fig. 2 is an exploded perspective view of the same light emitting device.
[Fig. 3] Fig. 3 (a) is a side cross-sectional view illustrating light paths exiting from a solid-state light emitting element in the same light emitting device, and Fig. 3 (b) is a side cross-sectional view illustrating a light distribution curve of the same light emitting device.
[Fig. 4] Fig. 4 (a) is a side cross-sectional view along a longer direction of an illumination device incorporating the same light emitting device, Fig. 4 (b) is a side cross-sectional view along a shorter direction, and Fig. 4 (c) is a top view.
[Fig. 5] Fig. 5 (a) is a side cross-sectional view along a shorter direction, which illustrates a variation of the same illumination device, Fig. 5(b) is a side cross-sectional view illustrating another variation, and Fig. 5 (c) is a side cross-sectional view illustrating still another variation.
[Fig. 6] Fig. 6 is an exploded perspective view of a light emitting device according to an embodiment of the present invention.
[Fig. 7] Fig. 7 is a side cross-sectional view along a shorter direction of the same light emitting device.
[Fig. 8] Fig. 8 (a) is a side cross-sectional view along a shorter direction of a light emitting device according to an embodiment of the present invention, and Fig. 8 (b) is a side cross-sectional view illustrating light paths exiting from a solid-state light emitting element in the same light emitting device.
[Fig. 9] Fig. 9 is an exploded perspective view of a light emitting device according to a fourth embodiment of the present invention.
[Fig. 10] Fig. 10 (a) is a cross-sectional view along an A-A' line in Fig. 9, Fig. 10 (b) is a top view of the same light emitting device, and Fig. 10 (c) is a top view illustrating light distribution in the same light emitting device.
[Fig. 11] Fig. 11 (a) is a cross-sectional view along a longer direction of a light distribution adjusting member used for a light emitting device according to a fifth embodiment of the present invention, Fig. 11 (b) is a top view, and Fig. 11 (c) is a top view illustrating light distribution in the same light emitting device.
[Fig. 12] Fig. 12 is a side cross-sectional view along a longer direction of an illumination device incorporating a variation of the same illumination device.
[Fig. 13] Fig. 13 (a) is a side cross-sectional view of a light emitting device according to an embodiment of the present invention, Fig. 13 (b) is a side cross-sectional view illustrating a light distribution curve of the same light emitting device, and Fig. 13] (c) is a top view.
[Fig. 14] Fig. 14 (a) is a side cross-sectional view in a variation of the same light emitting device, and Fig. 14 (b) is a side cross-sectional view illustrating a light distribution curve of the same light emitting device.
[Fig. 15] Fig. 15 is a side cross-sectional view in another variation of the same light emitting device.
[Fig. 16] Fig. 16 (a) is a side cross-sectional view of a light emitting device according to an embodiment of the present invention, and Fig. 16 (b) is a top view.
[Fig. 17] Fig. 17 (a) is a top view illustrating a configuration using a plurality of pairs of solid-state light emitting elements and wavelength converting members in the same light emitting device, Fig. 17 (b) is a side cross sectional view along a longer direction of an illumination device incorporating the same light emitting device, Fig. 17 (c) is a side cross-sectional view along a shorter direction, and Fig. 17 (d) is a top view.
[Fig. 18] Fig. 18 (a) is a top view illustrating a configuration in which in the light emitting device according to the embodiment ofFig. 16 and 17 , pluralities of solid-state light emitting elements and wavelength converting members are used, Fig. 18 (b) is a top view of an illumination device incorporating the same light emitting device, and Fig. 18 (c) is a partial side cross-sectional view of the same illumination device.
[Fig. 19] Fig. 19 (a) is a side view of a conventional light emitting device, and Fig. 19 (b) is a diagram illustrating a light distribution curve of the light emitting device.
[Fig. 20] Fig. 20 (a) is a side cross-sectional view of an illumination device incorporating a plurality of conventional light emitting devices, and Fig. 20 (b) is diagram illustrating luminance distribution as viewed from a top surface of the same illumination device.

### [Best Mode for Carrying Out the Invention]

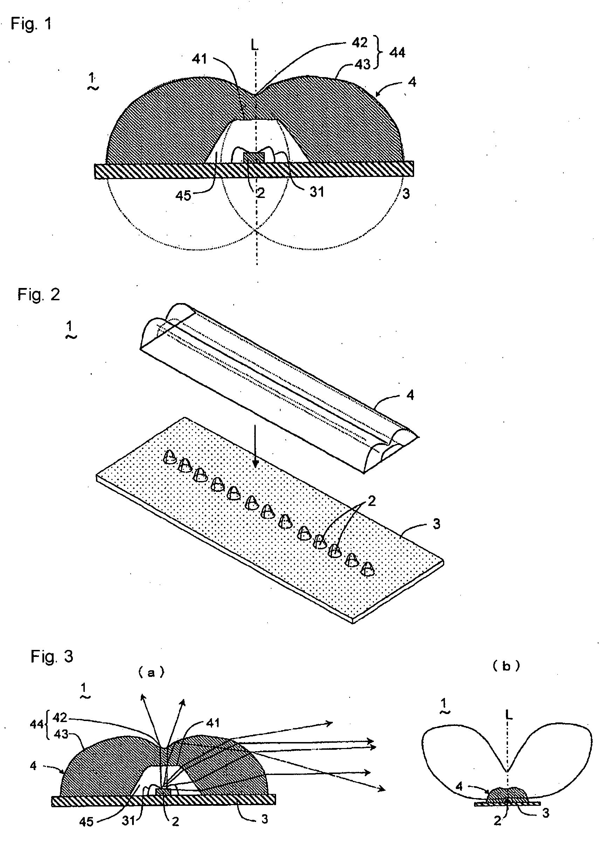

A light emitting device according to a conventional embodiment of the present invention and an illumination device using the light emitting device are described referring to Figs. 1 to 4. A light emitting device 1 of the present embodiment is, as illustrated in Figs. 1 and 2, provided with: a plurality of light emitting diodes (hereinafter referred to as LEDs) 2 as solid-state light emitting elements; a wiring board (hereinafter referred to as a board) 3 on which the LEDs 2 are assembled in an array; and a light distribution adjusting member 4 that adjusts distribution of light emitted from the LEDs 2. The light distribution adjusting member 4 is provided with being shared by at least two or more LEDs 2 among the LEDs 2 arranged in an array. Also, the light distribution adjusting member 4 has: a containing part 41 that contains the LEDs 2; a concavely curved surface part 42 that is provided above light lead-out surfaces of the LEDs 2 and immediately above the LEDs 2; and a pair of convexly curved surface parts 43 that are provided on both sides of the concavely curved surface part 42 and smoothly continuous with the concavely curved surface part 42 in terms of surface. Each of the convexly curved surface parts 43 is configured to have a hemispherical surface that is obtained by sweeping an arc (indicated by a dotted line in Fig. 1) constituting a substantially precise circle having a center in a board 3. The concavely curved surface part 42 is a surface that is curved in a direction opposite to a curvature direction of the convexly curved surface parts 43; a surface that is smoothly continuous with the pair of convexly curved surface parts 43; and a surface that is orthogonal to light lead-out axes L passing through central parts of light exit surfaces of the LEDs 2.

The LEDs 2 are not particularly limited if they serve as a light source that can emit light having a desired light color as the light emitting device 1; however, as the LEDs 2, GaN based blue LED chips that emit blue light having an emission peak wavelength of 460 nm are preferably used. A size of the LED 2 is also not particularly limited; however, LED chips having a size of 0.3 square mm is preferable. In the present embodiment, as each of the LEDs 2, a so-called face-up type element of which an upper surface is provided with respective electrodes of anode and cathode is used. As a method for assembling the LEDs 2, the LEDs 2 are bonded onto the board 3 by a die bond material (not illustrated), and the respective electrodes provided on the element upper surfaces of the LEDs 2 are connected to a wiring pattern (not illustrated) provided on the board 3 with use of wires 31. This causes the LEDs 2 and the wiring pattern to be electrically connected. As the die bond material, for example, a silicone based resin, silver paste, other highly heat resistant epoxy based resin, or the like is used. In addition, here, as the method for assembling the LEDs 2, an example of assembling the face-up type elements by die bonding and wire bonding is described; however, each of the LEDs 2 may be a face-down type element of which electrodes are arranged on a lower surface side, and in such a case, the LEDs 2 are assembled by, for example, flip-chip assembling.

For the board 3, as a base material, a general purpose plate material for board such as a glass epoxy resin is preferably used. Alternatively, a ceramic board such as alumina or aluminum nitride, or a metal board of which a surface is provided with an insulating layer is also possible. On the board 3, the wiring pattern for supplying electricity to the LEDs 2 is provided. A size and a shape of the board 3 are only required to be a size and shape that enable mounted members such as the LEDs 2 and the light distribution adjusting member 4 to be mounted, and a thickness is only required to almost have strength that prevents deformation such as deflection from occurring at the time of handling. In addition, in the case of using the above-described LEDs 2 having the 0.3 square mm size, a long-sized rectangular board 3 having a size of, for example, 40 mm × 200 mm is used although depending on the number of the LEDs 2.

The wiring pattern formed on the board 3 is formed by, for example, a method for plating an Au surface. Metal used for the plating method is not limited to Au, but may be, for example, Ag, Cu, Ni, or the like. Also, Au on the surface of each pattern part may have a stacking structure such as Au/Ni/Ag in order to increase adhesive force to the board 3. In addition, the wiring pattern may be configured such that the surface thereof is subjected to a light reflection process to reflect light exiting from the LED 2 toward the board 3 side. Also, the surfaces of the board 3 and the wiring pattern are preferably covered by white resist except for regions necessary to connect the wires 31 and assembling the LED 2. The white resist is formed by a method such as a lift-off method. By doing so, each pattern part is protected by the white resist, so that wiring stability is improved, and handling at the time of assembling the light emitting device 1 in the illumination device is facilitated to improve manufacturing efficiency of the device.

As the wires 31, for example, general purpose gold wires are used. Alternatively, aluminum wires, silver wires, copper wires, or the like are also possible. The wires 31 are bonded to the respective electrodes of the LED 2 and the wiring pattern by a publicly known bonding method such as thermal bonding or ultrasonic bonding.

The light distribution adjusting member 4 is configured such that a part immediately above the LEDs 2 on a surface facing to the board 3 is concavely formed to form the containing part 41 containing the LEDs 2 and the pair of convexly curved surface parts 43 are symmetrically provided with sandwiching the concavely curved surface part 42 facing to the containing part 41. Assuming that the containing part 41 serves as a light entrance surface that causes the light from the LEDs 2 to enter the light distribution adjusting member 4, the concavely curved surface part 42 and convexly curved surface parts 43 serve as a light lead-out surface 44 that causes light to be led out of the light distribution adjusting member 4. Also, between the LEDs 2 on the board 3 and the containing part 41, an air layer 45 intervenes. The light distribution adjusting member 4 is one that is formed in the above shape with use of a material having translucency such as an acrylic resin, a silicone resin, or glass so as to cover the LED 2 group.

Further, the containing part 41 is formed such that a gradient of a cross-sectional shape orthogonal to a longer direction of the light distribution adjusting member 4 decreases toward the light lead-out axes L passing through the central parts of the LEDs 2 (see Fig. 1). By doing so, light entering the vicinity of any of the light lead-out axes L of the containing part 41 can be further refracted toward lateral directions.

Next, how the light distribution of the light exiting from the LEDs 2 is controlled by the entrance of the light to the distribution adjusting member 4 is described referring to Figs. 3 (a) and (b). As illustrated in Fig. 3 (a), the light exiting from the LEDs 2 enters from the containing part 41; travels in the light distribution adjusting member 4; and enters the concavely curved surface part 42, and part of the light exits outside with being refracted. However, an entrance surface of the concavely curved surface part 42 is convex as viewed from the light entering from the containing part 41, and therefore in a position lateral to any of the light lead-out axes L of the LEDs 2, a light incident angle is large. For this reason, most of the light entering from the containing part 41 is fully reflected toward lateral directions without refraction or transmission, and enters the convexly curved surface parts 43 that are positioned in the lateral directions of the containing part 41. On the other hand, an entrance surface of each of the convexly curved surface parts 43 is concave as viewed from the light fully reflected by the concavely curved surface part 42, so that a light incident angle is small, and therefore the light is refracted by the concavely curved surface part 42 and further exits toward the lateral direction.

That is, regarding the light that exits from the LEDs 2 and enters the light distribution adjusting member 4, part of the light is refracted by and transmits through the containing part 41; however, most of the light is emitted from the convexly curved surface parts 43 in the lateral directions. For this reason, the light emitted from the light distribution adjusting member 4 is, as illustrated in Fig. 3 (b), emitted so as to draw a so-called batwing type light distribution curve in which an amount of exit light flux in the light lead-out axes L direction is small, and an amount of exit light flux in each of the lateral directions is large. Accordingly, the light emitting device 1 can broaden the light distribution of the light emitted from the LEDs 2 to reduce directionality specific to an LED light source.

Also, in the longer direction of the light distribution adjusting member 4, some light having a large incident angle is repetitively reflected and diffused by white resist (not illustrated) provided in the light distribution adjusting member 4 and on the board 3, and exits out of the light distribution adjusting member 4 while being led in the longer direction.

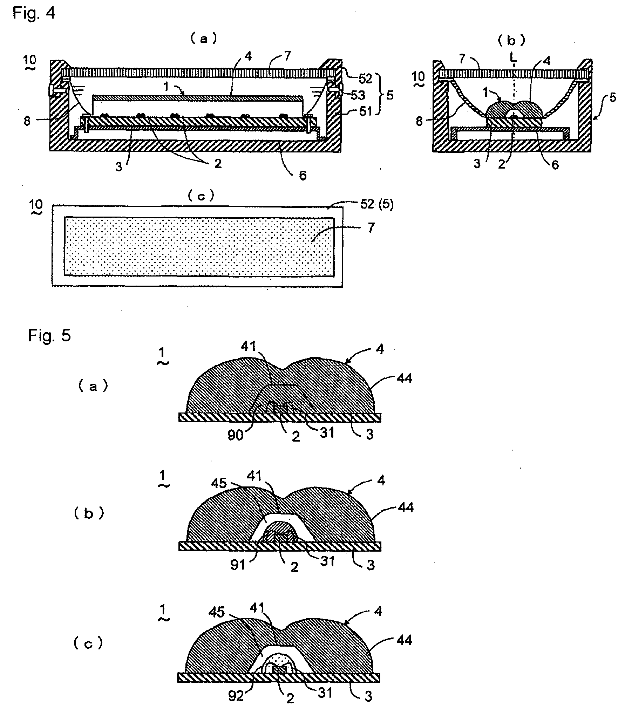

Next, referring to Figs. 4 (a) to (c), an illumination device 10 incorporating the light emitting device 1 provided with the plurality of LEDs 2 and the light distribution adjusting member 4 is described. The illumination device 10 is provided with: a main body part 5; an attachment plate 6 for fixing the light emitting device 1 to the main body part 5; a light diffusion transmission panel (hereinafter referred to as a light diffusing panel) 7 that is provided in a light lead-out direction of the light emitting device 1; and a reflector 8 that reflects light emitted from the light emitting device 1 toward a light diffusing panel 7. Note that the present embodiment exemplifies the illumination device 10 on the assumption of a base light having a long-sized shape; however, the illumination device 10 may be configured such that, for example, a plurality of lines each in which the LEDs 2 or the like are arranged on the board 3 having a regular rectangular shape in an array are arranged, and a shape and the like thereof are not particularly limited.

The main body part 5 is provided with: an attachment frame 51 that has a bottom surface fixed with the light emitting device 1; and an opening frame 52 that is attached on an opening side of the attachment frame 51 and holds the light diffusing panel 7. The attachment frame 51 is a can-shaped structural member of which a front surface is opened, and to be able to contain the light emitting device 1, provided with: a rectangular bottom surface part that is larger than the board 3; and a side surface part that is provided upright on four sides of the bottom surface part. The side surface part of the attachment frame 51 is formed such that an outer peripheral edge on the opening side is thinner, and configured as a fitted part. By fitting the side surface part of the opening frame 52 into the fitted part and inserting screws 53 from outside, the attachment frame 51 and the opening frame 52 are fixed to each other. The opening frame 52 is a frame-shaped member of which the center is opened to emit light, and also to hold the light diffusing panel 7, configured such that a peripheral edge of an opening part protrudes inward. Also, the opening part of the opening frame 52 is larger in size than the board 3, and also formed such that, toward the light lead-out direction, an opening area is made larger. The attachment frame 51 and the opening frame 52 are fabricated by, for example, pressing a plate material having predetermined rigidity, such as an aluminum plate or a steel plate, into a predetermined shape. An inner surface of the attachment frame 51 is coated with white paint or the like.

The attachment plate 6 is a member that holds the light emitting device 1 so as to be able to form a gap between the board 3 of the light emitting device 1 and the bottom surface of the attachment frame 51, and fabricated by pressing a plate material having predetermined rigidity, such as an aluminum plate or steel plate, into the above shape. The board 3 of the light emitting device 1 and the attachment plate 6 are fixed to each other by screws 61 that penetrate through them. The attachment plate 6 is fixed to the attachment frame 51 by screws (not illustrated), adhesion, or the like. Alternatively, for example, a predetermined resin plate or clips may be used to fix an end part of the board 3 and the attachment plate 6 to each other with sandwiching them (not illustrated). The attachment plate 6 is preferably formed of a material having good thermal conductivity so as to be able to efficiently radiate heat from the light emitting device 1. Also, on a surface facing to the bottom surface of the attachment frame 51, heat radiation fins may be formed. Between the board 3 and the bottom surface of the attachment frame 51, a power source part, wirings, and the like (not illustrated) for lighting and driving the light emitting device 1 are contained.

The light diffusing panel 7 is a rectangular plate-like member fabricated by forming and processing a milky white material, which is obtained by adding diffusing particles such as titanium oxide to a translucent resin such as an acrylic resin, into substantially the same shape as an inner shape of the opening frame 52. Alternatively, the light diffusing panel 7 may be such as one fabricated by sandblasting or embossing a front or back surface of a transparent glass plate or a resin plate to form a rough surface.

The reflector 8 is one configured such that a pair of curved plate materials having reflectivity is arranged on both sides along the longer direction of the LEDs 2 arranged on the board 3 in a matrix and the light distribution adjusting member 4 covering them, and also arranged so as to slope with respect to the light lead-out axes L (Fig. 4 (b)). As the reflector 8, a light diffuse reflector fabricated by, for example, coating highly reflective white paint on a resin structure formed in the above shape is preferably used. The reflector 8 may be one having a surface on which silver or aluminum having a higher reflectance is evaporated.

In the illumination device 10 configured as described above, the light emitted from the light emitting device 1 enters the light diffusing panel 7 directly or through the reflector 8, and exits out of the illumination device 10. At this time, even in the case where the light diffusing panel 7 is arranged close to the light emitting device 1, the light emitting device 1 emits the light having the batwing light distribution through the light distribution adjusting member 4 as illustrated in Fig. 3 (b), and therefore the light entering the light diffusion panel 7 has low directionality. The light is further diffused by the light diffusing panel 7 and then exits, and therefore the illumination device 10 can show as if a whole of the light diffusing panel 7 lights, and also uniform luminance distribution of the light diffusing panel 7. Further, the light diffusing panel 7 can be arranged close to the light emitting device 1, and therefore the illumination device 10 can be made thinner.

Also, the light emitting device 1 can emits the light at wide angles, and therefore in the case of surrounding it with the reflector 8, an amount of light entering the reflector 8 is increased. Accordingly, by adjusting a shape or the like of a reflecting surface of the reflector 8, the illumination device 10 having high light distribution controllability can be realized. Further, on an exit surface of the light diffusing panel 7 of the illumination device 10, a sense of grains specific to the LED 2 light source can be suppressed to reduce glare.

Next, variations of the illumination device 10 of the present embodiment are described referring to Figs. 5 (a) to (c). The variation illustrated in Fig. 5 (a) is one in which the light lead-out surfaces of the LEDs 2 are covered by a transparent resin 90. In this variation, in a space surrounded by the containing part 41 of the light distribution adjusting member 4 and the board 3, the transparent resin 90 is filled. According to this configuration, the transparent resin 90 can protect the LEDs 2 and the wires 31 for supplying electricity to the LEDs 2, so that disconnection or the like of the wires 3 is unlikely to occur, and therefore reliability of the device can be improved. As the transparent resin 90, for example, the same one as a resin constituting the light distribution adjusting member 4 is used. Alternatively, for example, a material having a refractive index that is intermediate between a refractive index of a material constituting the light exit surfaces of the LEDs 2 and a refractive index of a material constituting the light distribution adjusting member 4 can be used. By doing so, full reflection at each of interfaces between the light exit surfaces of the LEDs 2 and the transparent resin 90 and between the transparent resin 90 and the light distribution adjusting member 4 can be suppressed, and therefore the light exiting from the LEDs 2 can be efficiently led to the light distribution adjusting member 4 to improve light use efficiency.

The variation illustrated in Fig. 5 (b) is one in which the light lead-out surfaces of the LEDs 2 are covered by a hemispherically formed transparent resin member 91; however, in this variation, between the transparent resin member 91 and the containing part 41 of the light distribution adjusting member 4, the air layer 45 intervenes. Methods for forming the hemispherical transparent resin member 91 include, for example, a method that fills the transparent resin in a mold having a predetermined shape, and places the board 3 assembled with the LEDs 2 on an upper surface of the resin in the mold in a reversed state to cure the resin. Alternatively, a possible method is a method that prepares, with use of the transparent resin, a bowl-shaped molding provided with a concave portion as a space for placing the LEDs 2; fills the same resin as that for the molding in the concave portion; places the LEDs 2 on the board 3 so as to cover the LEDs 2; and cures the resin. Even in this configuration, as in the above variation, the LEDs 2 and the wires 31 can be protected.

The variation illustrated in Fig. 5 (c) is one in which the light lead-out surfaces of the LEDs 2 are covered by a wavelength converting member 92 formed by containing phosphors in a resin that constitutes the hemispherical transparent resin member 91 illustrated in above Fig. 5 (b). According to this configuration, the LEDs 2 and wires 31 can be protected, and further a wavelength of the exit light from the LEDs 2 can be converted to cause light having any light color to exit.

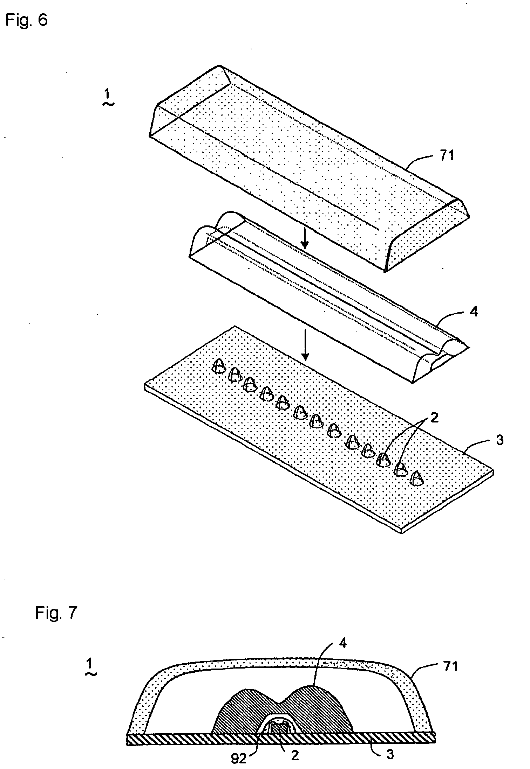

Next, a light emitting device according to a conventional embodiment of the present invention is described referring to Figs. 6 and 7. The light emitting device 1 of the present embodiment is, as illustrated in Fig. 6, one that is further provided with a diffusion transmission cover member (hereinafter referred to as a diffusing cover) 71 that covers the light distribution adjusting member 4. In addition, in the present embodiment as well, as illustrated in Fig. 7, light lead-out surfaces of LEDs 2 are covered by a hemispherically formed wavelength converting member 92.

The diffusing cover 71 is a can-shaped optical member that has a surface facing to the board 3, which is opened, and thereby has a containing space that can contain the light distribution adjusting member 4, and formed of a milky white material obtained by adding white paint to the translucent resin such as the acrylic resin. Further, as illustrated in Fig. 7, in a cross section in a shorter direction of the diffusing cover 71, a surface facing to the board 3, and both side surface parts of the diffusing cover 71 are formed continuously with each other by curved surfaces. By doing so, light unevenness in such a position can be suppressed.

According to the present embodiment, light can be emitted from the side surfaces of the diffusing cover 71, and therefore a wider range can be illuminated. Also, without using the main body part 5 or the light diffusing panel 7 used for the illumination device 1 in the above-described conventional embodiment according to Fig. 1, only by arranging a power source part and the like, the illumination device 10 can be assembled, and therefore device assembling can be simplified to improve manufacturing efficiency. Further, the main body part 5 is not required, and therefore the illumination device 10 can be further made thinner.

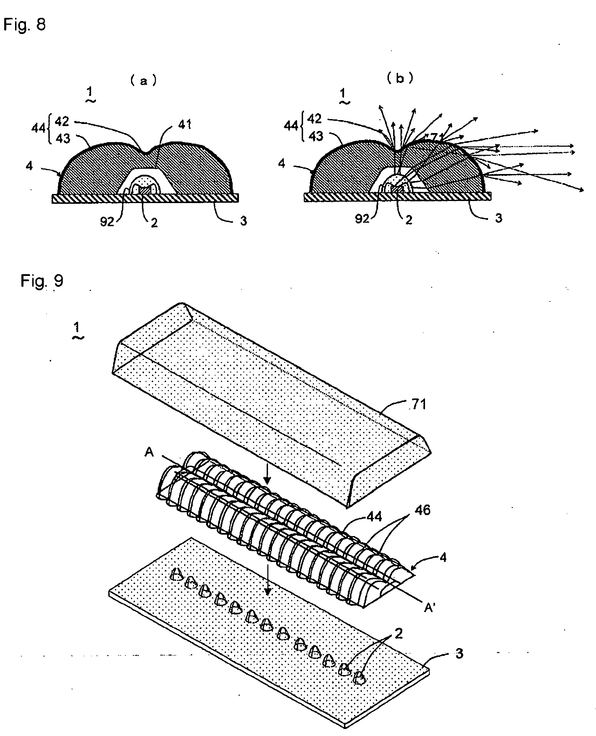

Next, a light emitting device according to an embodiment of the present invention and an illumination device using the light emitting device are described referring to Fig. 8. The light emitting device 1 of the present embodiment is, as illustrated in Fig. 8 (a), one in which the light lead-out surface 44 of the light distribution adjusting member 4 is formed as a rough surface. In the illustration, a part corresponding to the rough surface is indicated by a thick line. Surface roughening of the light lead-out surface 44 is performed by sandblasting under the condition of #100 roughness. A ratio in area between fine concave portions and smooth portions on the rough surface is, for example, approximately 1:1; however, without limitation to this, the ratio is appropriately adjusted depending on light distribution of exit light from the light distribution adjusting member 4. The same holds true for a particle size in the sandblasting.

Meanwhile, if the light lead-out surface 44 is a smooth surface, light (direct light) that is refracted by and transmits through the light lead-out surface 44 of the light distribution adjusting member 4 without being fully reflected by the light lead-out surface 44, and light (fully reflected light) that is fully reflected once or more by the light lead-out surface 44 and then exits out of the light lead-out surface 44 are likely to give rise to sparseness and denseness in light distribution. For this reason, in the illumination device 10 (see Fig. 4 (a)) incorporating the light emitting device 1, the light diffusing panel 7 may give rise to luminance unevenness. On the other hand, by performing the surface roughening of the light lead-out surface 44 of the light distribution adjusting member 4, a degree of the sparseness and denseness can be reduced, and therefore the luminance unevenness on the light diffusing panel 7 can be suppressed to further uniform luminance distribution on the light diffusing panel 7.

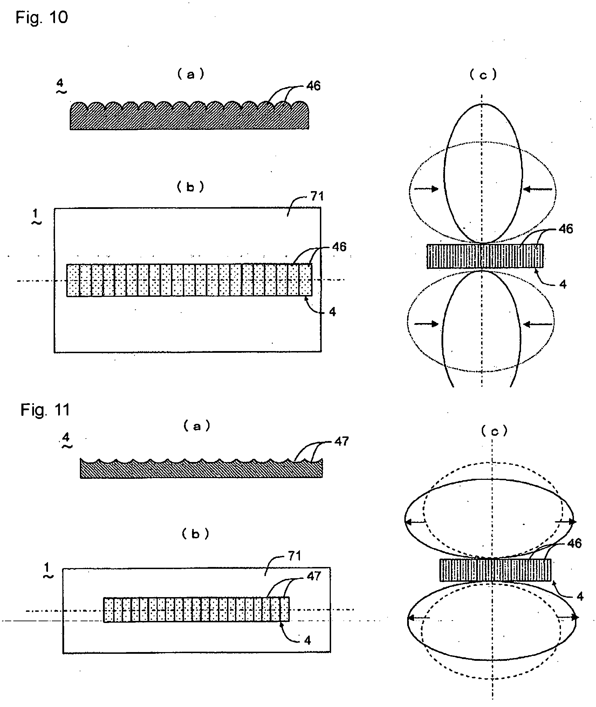

Next, a light emitting device according to an embodiment of the present invention is described referring to Figs. 9 and 10. The light emitting device 1 of the present embodiment is, as illustrated in Fig. 9, one in which the light lead-out surface 44 of the light distribution adjusting member 4 is provided with a plurality of convex lenses 46 in a longer direction. Fig. 10 (a) illustrates an A-A' cross section in Fig. 9. In the present embodiment as well, as in the above conventional embodiment according to Fig. 6, the diffusing cover 71 is provided. The diffusing cover 71 is, as illustrated in Fig. 10 (b), formed to have, as compared with the light distribution adjusting member 4, substantially the same longer direction length and an increased shorter direction length.

Light distribution of the light emitting device 1 is illustrated in Fig. 10 (c). In the same diagram, light distribution for the case of using the light distribution adjusting member 4 provided with the plurality of convex lenses 46 is indicated by a solid line, whereas light distribution for the case of using the light distribution adjusting member 4 not provided with any concave lens 46 is indicated by a dotted line. That is, according to the present embodiment, by providing the plurality of convex lenses 46 on the light lead-out surface 44 of the light distribution adjusting member 4, as illustrated in the same diagram, light distribution in a top view is narrowed by the convex lenses 46. Accordingly, an amount of light emitted in the shorter direction of the light distribution adjusting member 4 can be increased, and even in the case of arranging the diffusing cover 71 in the same direction, shorter direction luminance distribution on a light exit surface of the diffusing cover 71 can be uniformed. Also, the diffusing cover 71 can be brought close, and therefore the illumination device 10 using the light emitting device 1 can be further made thinner.

Next, a light emitting device according to an embodiment of the present invention and an illumination device using the light emitting device are described referring to Fig. 11. The light emitting device 1 of the present embodiment is, as illustrated in Fig. 11 (a), one in which a light exit surface of the light distribution adjusting member 4 is provided with a plurality of concave lenses 47 in a longer direction. Also, in the present embodiment as well, as in the above embodiment according to Fig. 6 or according to Fig. 9, the diffusing cover 71 is provided; however, the diffusing cover 71 is, as illustrated in Fig. 11 (b), formed to have, as compared with the light distribution adjusting member 4, slightly large longer direction and shorter direction lengths. The rest of a configuration is the same as that of the above fourth embodiment.

Regarding light distribution of the light emitting device 1, as illustrated in Fig. 11 (c), light distribution (solid line) for the case of using the light distribution adjusting member 4 provided with the plurality of concave lenses 47 is broaden in a longer direction of the light distribution adjusting member 4 more widely than light distribution (dotted line) for the case of using the light distribution adjusting member 4 not provided with any concave lens 47. That is, according to the present embodiment, exit lights from any adjacent LEDs 2 that are arranged in an array can be effectively mixed to uniform longer direction luminance distribution on a light exit surface of the diffusing cover 71.

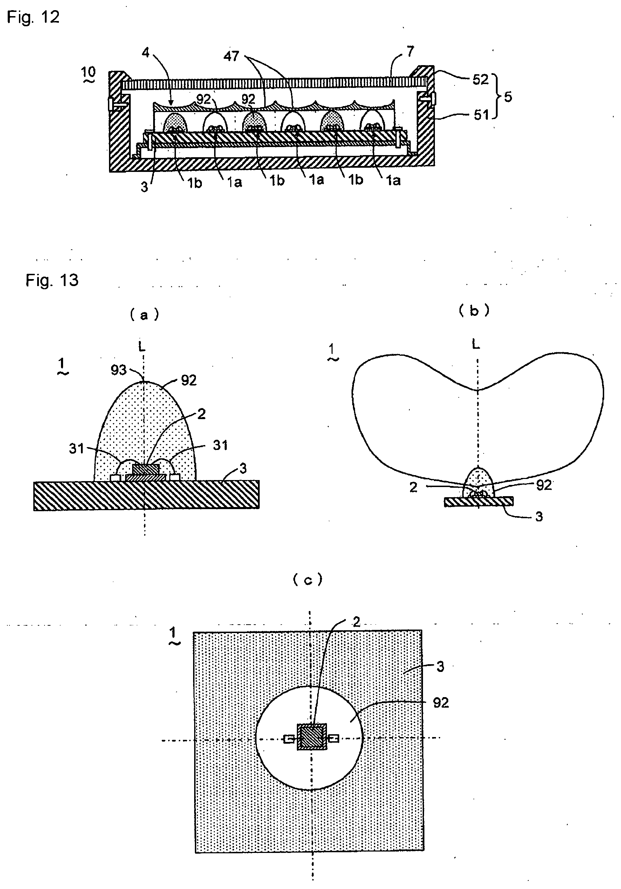

Next, referring to Fig. 12, the illumination device 10 using light emitting devices according to a variation of the present embodiment is described. The illumination device 1 according to this variation is one that uses the light distribution adjusting member 4 provided with the plurality of concave lenses 47 and also uses the light emitting devices 1 respectively having different emission colors. Light color of exit light of each of the light emitting devices 1 is set to any chromaticity by adjusting, besides the type of a chip used for each LED 2, or the type or additive amount of phosphors used for the wavelength converting member 92, dye, paint, or the like added to the wavelength converting member 92. Light color of irradiation light of the illumination device 10 is different depending on a use environment or the like of the illumination device 10; however, in the case of a general illumination device for a living room, for example, as illustrated in the diagram, a combination of light emitting devices 1a that emit white light and light emitting devices 1b that emit electric bulb color light is cited.

In a conventional LED illumination device, lights respectively having different light colors are mixed by the light diffusing panel 7 to some extent; however, in the case where a distance between light emitting devices 1 and the light diffusing panel 7 is close, the lights may not be fully mixed, and on an exit surface of the light diffusing panel 7, color unevenness may occur. On the other hand, in this variation, the light distribution adjusting member 4 provided with the plurality of concave lenses 47 is used, and therefore color mixture of the exit lights from the respective light emitting devices 1a and 1b is facilitated. Accordingly, from an exit surface of the light diffusing panel 7, light resulting from mixing the white light and the electric bulb color light uniformly exits, and thereby color unevenness of the illumination device 10 can be suppressed. Note that the color lights of the light emitting devices 1 are not limited to the above-described white light and electric bulb color light, but for example, a plurality of light emitting devices respectively emitting red (R) light, green (G) light, and blue (B) light can be used

Next, a light emitting device according to an embodiment of the present invention is described referring to Figs. 13 (a) to (c). The light emitting device 1 of the present embodiment is one that is provided with the wavelength converting member 92 that converts emission light of the LED 2 in terms of wavelength, in which the wavelength converting member 92 is formed so as to have, in a vertical cross-sectional view that is orthogonal to a longer direction of the light distribution adjusting member 4, an upward thickness thicker than a thickness in a lateral direction of the LED 2.

In the present embodiment, the wavelength converting member 92 is, in the present embodiment, formed in a vertically-long convex shape and also a semielliptical shape of which a vertical cross section has a major axis in a height direction, so as to, in the vertical cross-sectional view, have the upward thickness thicker than the thickness in the lateral direction of the LED 2 and also have the apex part 93 in the light lead-out direction. A ratio between the major axis and a minor axis is set to, for example, 2:1, but not limited to this.

The wavelength converting member 92 is an optical member that is fabricated by forming and processing into the above-described shape a mixed material in which in a resin material having translucency (for example, a silicone resin), particulate yellow phosphors that are excited by the blue light exiting from the LED 2 and emits yellow light are dispersed. As the resin material having translucency, for example, a silicone resin having a refractive index of 1.2 to 1.5 is used.

As the phosphors, the well known yellow phosphors that are excited by absorbing part of the blue light exiting from the LED 2, and have a peak wavelength in a wavelength range of 500 to 600 nm are preferably used. The yellow phosphors have the emission peak wavelength in the yellow wavelength range and also have an emission wavelength range including a red wavelength range. As the yellow phosphors, so-called YAG based phosphors including garnet structure crystals of composite oxide of yttrium and aluminum are cited, but without limitation to them. For example, in order to adjust a color temperature or color rendering property, or for other purpose, a plurality of different color phosphors may be mixed, and by appropriately mixing red phosphors and green phosphors, white light having a high color rendering property can be obtained. In addition, the resin material constituting the wavelength converting member 92 may be, in addition to the above phosphors, added with, for example, a light diffusing material, filler, or the like. The wavelength converting member 92 is formed in the same manner as that for the above-described transparent resin member 91 illustrated in Fig. 5 (b).

The light emitted from the LED 2 exits radially around the light lead-out axis L. Then, part of the light collides with the phosphors contained in the wavelength converting member 92 to cause the phosphors in a ground state to transit to an excited state. The phosphors in the excited state emit light having a different wavelength from that of the light from the LED 2 to return to the ground state. This enables the phosphors to emit the light resulting from converting the wavelength of the light from the LED 2. The light resulting from the wavelength-conversion by the phosphors radially exits from the phosphors regardless of the direction of the light lead-out axis L. That is, the light emitted from the LED 2 is not only wavelength-converted by the phosphors, but radially diffused without traveling in a traveling direction of the light emitted from the LED 2. Also, the wavelength-converted light can be further diffused by surfaces of the other phosphors.

In the present embodiment, the wavelength converting member 92 has, in the vertical cross-sectional view, the upward thickness thicker than the thickness in the lateral direction of the LED 2, and therefore from among the light emitted from the LED 2, light traveling in a light lead-out axis L direction travels the longest distance inside the wavelength converting member 92. Accordingly, the light traveling in the light lead-out axis L direction has a higher probability of colliding with the phosphors because the traveling distance (light path) inside the wavelength converting member 92 is longer, and is therefore blocked from traveling in the light lead-out axis L direction. As a result, in the vertical cross-sectional view of the wavelength converting member 92, as the upward thickness is increased further than the thickness in the lateral direction of the LED 2, an amount of the light traveling in the light lead-out axis L direction decreases. Further, the light converted by the phosphors exits as approximately diffused light distribution (e.g., BZ5 in BZ classification) with respect to an exit surface of the wavelength converting member 4. Accordingly, as a ratio of a surface area facing in the lateral direction to a surface area facing in the upward direction is increased, light distribution that is further laterally broadened is obtained.

That is, light emitted from the wavelength converting member 92 is, as illustrated in Fig. 13 (b), emitted so as to draw a so-called batwing type light distribution curve in which an amount of luminous flux in the light lead-out axis L direction is small and an amount of luminous flux in the lateral direction is large. Accordingly, the light emitting device 1 can broaden the distribution of the light emitted from the LED 2 to reduce directionality specific to an LED light source.

Also, in the illumination device 1 incorporating the light emitting device 1, an amount of light exiting in a lateral direction can be increased by the wavelength converting member 92 even in a longer direction of the light distribution adjusting member 4, and thereby broader light distribution can be achieved.

Further, as illustrated in Fig. 13 (c), the wavelength converting member 92 is circular in a top view, and therefore the light isotropically exits in lateral directions of the LED 2. Accordingly, in the case where a plurality of light emitting devices 1 are arranged in an array, light can be evenly irradiated to the light diffusing panel 7 to uniform luminance distribution on the light diffusing panel 7.

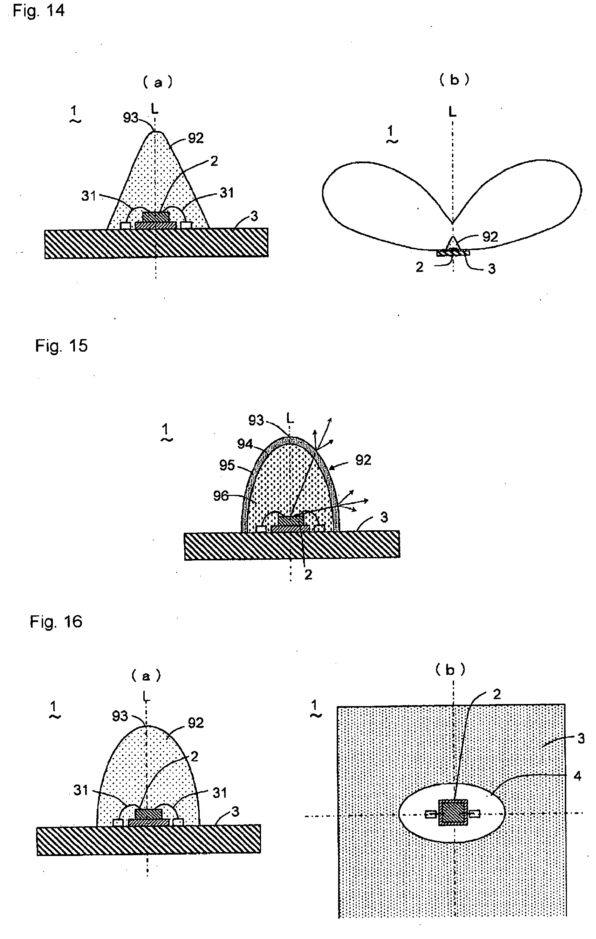

Next, variations of the light emitting device 1 of the present embodiment are described referring to Figs. 14 (a) and (b) and 15. The variation illustrated in Fig. 14 (a) is one in which the wavelength converting member 92 is formed in a vertically-long triangular shape in a vertical cross-sectional view. Note that an apex part 93 of the wavelength converting member 92 is not conical or pyramidal, but formed to have a predetermined roundness. The rest of a configuration is the same as that of the above-described embodiment.

In the wavelength converting member 92, from among light emitted from the LED 2, light traveling in the light lead-out axis L direction travels long distance inside the wavelength converting member 92 and then exits, and is therefore blocked by phosphors contained in the wavelength converting member 92 from traveling in the light lead-out axis L direction. Further, light resulting from conversion by the phosphors exits as approximately diffused light distribution (BZ5) with respect to an exit surface of the wavelength converting member 4. As a result, a ratio of a surface area facing laterally is larger than that in the above conventional embodiment according to Fig. 1, and therefore as illustrated in Fig. 14 (b), batwing light distribution becomes more significant.

According to this configuration, in the illumination device 10 (see Fig.4 (b)) using the light emitting device 1, a distance between the light diffusing panel 7 and the light emitting device 1 can be further reduced to make the illumination device 10 thinner. Also, light distribution controllability by the reflector 8 can be further improved.

The variation illustrated in Fig. 15 is one configured such that the wavelength converting member 92 has a concave portion 94 on a surface facing to the LED 2, and is formed as a thin member 95 having a uniform thickness, and in the concave portion 94, a transparent resin 96 is filled. The thin member 95 is a member that is formed by coating a phosphor-containing resin on the hemispherical transparent resin 96 formed to cover the LED 2, or by covering a phosphor sheet on the transparent resin 96. A thickness of the wavelength converting member 92 (thin member 95) is set to, for example, 0.1 to 0.5 mm. As the transparent resin 96, the same resin as that configuring the thin member 95 is used except for not containing any phosphor, and for example, a silicone resin or the like is preferably used.

In the case where, as described above, the shape of the wavelength converting member 92 is a semielliptical shape having a major axis upward, a difference in light path length of exit light from the LED 2 occurs inside the wavelength converting member 92, and therefore color unevenness may occur. On the other hand, by forming the thickness of the wavelength converting member 92 so as to be thin and uniform, regardless of a shape of the wavelength converting member 92, light path lengths inside the wavelength converting member 92 (thin member 95) are uniformed, and therefore the color unevenness can be suppressed.

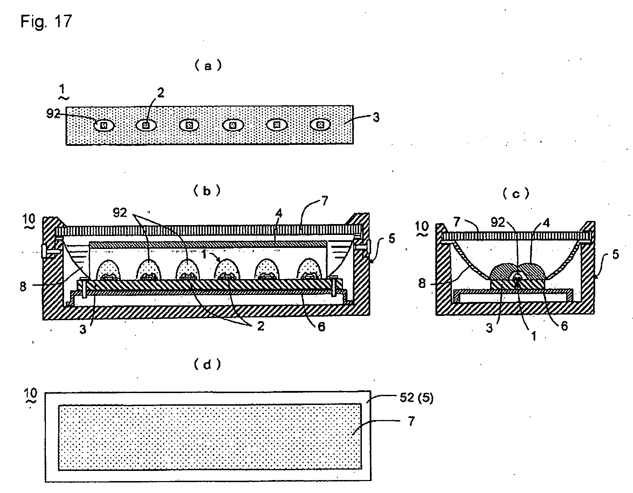

Next, a light emitting device according to an embodiment of the present invention and an illumination device using the light emitting device are described referring to Figs. 16 and 17. The light emitting device 1 of the present embodiment is configured such that the wavelength converting member 92 is, as illustrated in Fig. 16 (a), the same as that of the above embodiment according to Fig. 13 in terms of a vertical cross sectional shape, but, as illustrated in Fig. 16 (b), formed in an elliptical shape in a top view of the wavelength converting member 92.

In the wavelength converting member 92 formed in the elliptical shape in the top view, regarding an side surface area of the wavelength converting member 92, an area as viewed from a minor axis direction is larger than an area as viewed from a major axis direction, and therefore an amount of exit luminous flux in the minor axis direction is large as compared with that in the major axis direction.

As illustrated in Figs. 17 (a) to (d), in the illumination device 10 incorporating the plurality of light emitting devices 1 respectively provided with the plurality of pairs of LEDs 2 and the wavelength converting members 92, the plurality of light emitting devices 1 are arranged on the long-sized board 3 in an array along the major axis direction of the wavelength converting members 4 The rest of a configuration of the illumination device 10 is the same as that illustrated in the above-described conventional embodiment according to Fig. 1 (see Fig. 4).

In the present embodiment, if on the long-sized board 3, the plurality of light emitting devices are arranged in one line at regular intervals, an amount of light in a shorter direction of the board 3 can be increased. Based on this, in the case where an interval between adjacent lines among lines in which the plurality of light emitting devices 1 are arranged in array is large, even if the light diffusing panel 7 is arranged close to the light emitting devices 1, light unevenness does not occur in each of the lines, and therefore luminance distribution on the exit surface of the light diffusing panel 7 can be uniformed.

Next, a light emitting device according to an embodiment of the present invention and an illumination device using the same are described referring to Fig. 18. The light emitting device 1 of the present embodiment is, as illustrated in Fig. 18 (a), one in which a plurality of LEDs 2 are arranged on an annular board 3, and to correspond this, the light distribution adjusting member 4 is annularly formed. Also, as illustrated in Fig. 18 (b), a circular diffusing cover 71 is provided so as to cover the annular board 3 and the light distribution adjusting member 4. The board 3 is fixed to a disc-like fixture main body 54 by screws or the like. Further, as illustrated in Fig. 18 (c), in the substantially central part of the fixture main body 54, an attachment socket 55 is arranged, and the attachment socket 55 and a circuit formed on the board 3 are connected to each other through wirings. Also, on a back surface side of the fixture main body 54, a power source part (not illustrated) and the like are placed, and through the attachment socket 55, electrically connected to the light emitting device 1.

According to the present embodiment, by annularly arranging the LEDs 2 and the light distribution adjusting member 4, the surface-emitting illumination device having a round shape and uniform luminance distribution on a light exit surface can be realized.

Note that if the present invention is one that is provided with the light distribution adjusting member 4 that broadens light distribution in a direction orthogonal to an array direction of LEDs 2 arranged in an array, without limitation to any of the above-described embodiments, various modifications can be made. For example, by making the exit surface shape of the wavelength converting member 92 and a shape of the containing part 41 of the light distribution adjusting member 4 presented in the above-described embodiment according to Fig. 13 correspond to each other, the light exiting from the wavelength converting member 92 can also efficiently enters the light distribution adjusting member 4.

### [Description of Reference Numerals]

1: Light emitting device
10: Illumination device
2: LED (solid-state light emitting element)
4: Light distribution adjusting member
41: Containing part
42: Concavely curved surface part
43: Convexly curved surface part
44: Light lead-out surface
46: Convex lens
47: Concave lens
71: Diffusing cover (diffusion transmission cover member)
92: Wavelength converting member
L: Light lead-out axis

## Claims

1. A light emitting device (1) comprising:
a plurality of solid-state light emitting elements (2);
a board that is assembled with the solid-state light emitting elements (2) in an array; and
a light distribution adjusting member (4) that adjusts light distribution of light emitted from the solid-state light emitting elements (2), wherein
the light distribution adjusting member (4) is provided with being shared by at least two or more solid-state light emitting elements (2) among the solid-state light emitting elements (2) arranged in an array, and has:
a containing part (41) that contains the, solid-state light emitting elements (2);
a concavely curved surface part (42) that is provided above light lead-out surfaces of the solid-state light emitting elements (2) and also immediately above the solid-state light emitting elements (2); and
a pair of convexly curved surface part (43) that are provided on both sides of the concavely curved surface part (42) and smoothly continuous with the concavely curved surface part (42) in terms of surface;
the light lead-out surfaces of the solid-state light emitting elements (2) are covered by a transparent resin, **characterized in that** the transparent resin is configured as a wavelength converting member (92) with containing a phosphor, wherein the wavelength converting member (92) is formed so as to have, in a vertical cross-sectional view orthogonal to a longer direction of the light distribution adjusting member (4), an upward thickness that is thicker than a thickness in a lateral direction of the solid-state light emitting elements (2), and wherein the wavelength converting member (92) is formed in a vertically-long convex shape in the vertical cross-sectional view orthogonal to the longer direction of the light distribution adjusting member (4).

2. The light emitting device according to claim 1, further comprising
a diffusion transmission cover member (71) that covers the light distribution adjusting member (4).

3. The light emitting device according to claim 1 or 2, wherein
a light lead-out surface (44) of the light distribution adjusting member (4) is a rough surface.

4. The light emitting device according to any one of claims 1 to 3, wherein
between the solid-state light emitting elements (2) and an inner surface of the containing part (41), an air layer intervenes.

5. The light emitting device according to any one of claims 1 to 4, wherein
the containing part (41) is formed such that a gradient of a cross-sectional shape orthogonal to a longer direction of the containing part (41) decreases toward any of light lead-out axes (L) that respectively pass through central parts of the solid-state light emitting elements (2).

6. The light emitting device according to any one of claims 1 to 5, wherein
a light exit surface of the light distribution adjusting member (4) is provided with a plurality of convex lenses (46) in a longer direction.

7. The light emitting device according to any one of claims 1 to 5, wherein
a light exit surface of the light distribution adjusting member (4) is provided with a plurality of concave lenses (47) in a longer direction.

8. The light emitting device according to any one of claims 1 to 7, wherein
the wavelength converting member (92) is formed in a circular shape in a top view.

9. The light emitting device according to any one of claims 1 to 7, wherein
the wavelength converting member (92) is formed in an elliptical shape along the longer direction of the light distribution adjusting member in a top view.

10. The light emitting device according to any one of claims 1 to 9, wherein
the wavelength converting member (92) is formed by coating a phosphor-containing resin on the transparent resin or attaching a phosphor sheet to the transparent resin.

11. The light emitting device according to any one of claims 1 to 10, wherein:
the plurality of solid-state light emitting elements (2) are linearly arranged; and
the light distribution adjusting member (4) is linearly configured.

12. The light emitting device according to any one of claims 1 to 10, wherein:
the plurality of solid-state light emitting elements (2) are annularly arranged; and
the light distribution adjusting member (4) is annularly formed.

13. An illumination device (10) using the light emitting device (1) according to any of claims 1 to 12.

## Patentansprüche

1. Beleuchtungseinrichtung (1) aufweisend:
eine Mehrzahl von Festkörperlichtemissionselementen (2);
eine Platte, die mit den Festkörperlichtemissionselementen (2) in einer Anordnung zusammengebaut ist; und
ein Lichtverteilungseinstellelement (4), das die Lichtverteilung des Lichts einstellt, das von den Festkörperlichtemissionselementen (2) emittiert wird, wobei
das Lichtverteilungseinstellelement (4) vorhanden ist, um von zumindest zwei oder mehr Festkörperlichtemissionselementen (2) unter den Festkörperlichtemissionselementen (2), die in einer Anordnung angeordnet sind, gemeinsam verwendet wird und aufweist:
einen Aufnahmeteil (41) der die Festkörperlichtemissionselementen (2) aufnimmt;
einen konkav gekrümmten Oberflächenteil (42), der oberhalb den Ausgangsflächen der Festkörperlichtemissionselemente (2) und auch unmittelbar über den Festkörperlichtemissionselementen (2) vorhanden ist; und
ein Paar von konvex gekrümmten Oberflächenteilen (43), die auf beiden Seiten des konkav gekrümmten Oberflächenteils (42) vorhanden sind und in Bezug auf die Oberfläche glatt kontinuierlich mit den konkav gekrümmten Oberflächenteil (42) sind;
wobei die Lichtaustrittsflächen der Festkörperlichtemissionselemente (2) durch ein transparentes Harz abgedeckt sind, **dadurch gekennzeichnet, dass** das transparente Harz als einen Phosphor enthaltendes Wellenlängenwandlungselement (92) ausgebildet ist, wobei das Wellenlängenwandlungselement (92) derart ausgeführt ist, dass es in einer vertikalen Querschnittsansicht rechtwinklig zu einer Längsrichtung des Lichtverteilungseinstellelements (4) eine Dicke nach oben aufweist, die dicker ist als die Dicke in einer seitlichen Richtung der Festkörperemissionselemente (2), und wobei das Wellenlängenwandlungselement (92) in einer vertikal länglichen konvexen Gestalt in der vertikalen Querschnittsansicht rechtwinklig zu der Längsrichtung des Lichtverteilungseinstellelements (4) ausgebildet ist.

2. Beleuchtungseinrichtung nach Anspruch 1, außerdem aufweisend ein Diffusionsübertragungsabdeckelement (71), das das Lichtverteilungseinstellelement (4) abdeckt.

3. Beleuchtungseinrichtung nach Anspruch 1 oder 2, wobei die Lichtaustrittsfläche (44) des Lichtverteilungseinstellelements (4) eine raue Oberfläche ist.

4. Beleuchtungseinrichtung nach einem der Ansprüche 1 bis 3, wobei zwischen den Festkörperlichtemissionselementen (2) und einer inneren Oberfläche des Aufnahmeteils (41) eine Luftschicht angeordnet ist.

5. Beleuchtungseinrichtung nach einem der Ansprüche 1 bis 4, wobei der Aufnahmeteil (41) derart ausgebildet ist, dass ein Gradient der Querschnittsgestalt rechtwinklig zu einer Längsrichtung des Aufnahmeteils (41) zu irgendeiner der Lichtaustrittsachsen (L) abnimmt, die jeweils durch die zentralen Teile der Festkörperlichtemissionselemente (2) verlaufen.

6. Beleuchtungseinrichtung nach irgendeinem der Ansprüche 1 bis 5, wobei eine Lichtausgangsfläche des Lichtverteilungseinstellelements (4) mit einer Mehrzahl von konvexen Linsen (46) in einer Längsrichtung versehen ist.

7. Beleuchtungseinrichtung nach irgendeinem der Ansprüche 1 bis 5, wobei eine Lichtausgangsfläche des Lichtverteilungseinstellelements (4) mit einer Mehrzahl von konkaven Linsen (47) in einer Längsrichtung versehen ist.

8. Beleuchtungseinrichtung nach irgendeinem der Ansprüche 1 bis 7, wobei das Wellenlängenwandlungselement (92) in Draufsicht in einer kreisförmigen Gestalt ausgeführt ist.

9. Beleuchtungseinrichtung nach irgendeinem der Ansprüche 1 bis 7, wobei das Wellenlängenwandlungselement (92) in einer Draufsicht entlang der Längsrichtung des Lichtverteilungseinstellelements in einer elliptischen Form ausgebildet ist.

10. Beleuchtungseinrichtung nach irgendeinem der Ansprüche 1 bis 9, wobei das Wellenlängenwandlungselement (92) durch Beschichten eines Phosphor enthaltenden Harzes auf dem transparenten Harz oder durch Anbringen einer Phosphorschicht auf dem transparenten Harz gebildet ist.

11. Beleuchtungseinrichtung nach irgendeinem der Ansprüche 1 bis 10, wobei:
die Mehrzahl von Festkörperlichtemissionselementen (2) linear angeordnet sind; und
das Lichtverteilungseinstellelement (4) linear ausgeführt ist.

12. Beleuchtungseinrichtung nach irgendeinem der Ansprüche 1 bis 10, wobei:
die Mehrzahl von Festkörperlichtemissionselementen (2) ringförmig angeordnet ist; und
das Lichtverteilungseinstellelement (4) ringförmig ausgebildet ist.

13. Beleuchtungsvorrichtung (10), die die Beleuchtungseinrichtung (1) nach irgendeinem der Ansprüche 1 bis 12 verwendet.

## Revendications

1. Dispositif électroluminescent (1) comprenant :
une pluralité d'éléments électroluminescents à l'état solide (2) ;
une carte qui est assemblée avec les éléments électroluminescents à l'état solide (2) en groupement ordonné ; et
un élément de réglage de distribution de lumière (4) qui règle la distribution de la lumière émise par les éléments électroluminescents à l'état solide (2), dans lequel
l'élément de réglage de distribution de lumière (4) est prévu pour être partagé par au moins deux éléments électroluminescents à l'état solide (2) ou plus parmi les éléments électroluminescents à l'état solide (2) disposés en un groupement ordonné, et comporte :
une partie de rétention (41) qui contient les éléments électroluminescents à l'état solide (2) ;
une partie de surface courbée de façon concave (42) qui est placée au-dessus de surfaces de sortie de lumière des éléments électroluminescents à l'état solide (2) et aussi immédiatement au-dessus des éléments électroluminescents à l'état solide (2) ; et
une paire de parties de surface courbées de façon convexe (43) qui sont placées des deux côtés de la partie de surface courbée de façon concave (42) et en continuité douce avec la partie de surface courbée de façon concave (42) relativement à la surface ;
les surfaces de sortie de lumière des éléments électroluminescents à l'état solide (2) sont recouvertes d'une résine transparente, **caractérisé en ce que** la résine transparente est configurée comme élément de conversion de longueur d'onde (92) qui contient un élément fluorescent, dans lequel l'élément de conversion de longueur d'onde (92) est formé de manière à avoir, dans une vue en coupe verticale orthogonale à une grande direction de l'élément de réglage de distribution de lumière (4), une épaisseur vers le haut qui est supérieure à une épaisseur dans une direction latérale des éléments électroluminescents à l'état solide (2), et dans lequel l'élément de conversion de longueur d'onde (92) est formé de façon à avoir une forme convexe verticalement longue dans la vue en coupe verticale orthogonale à la grande direction de l'élément de réglage de distribution de lumière (4).

2. Dispositif électroluminescent selon la revendication 1, comprenant en outre un élément couvrant de transmission de diffusion (71) qui couvre l'élément de réglage de distribution de lumière (4).

3. Dispositif électroluminescent selon la revendication 1 ou 2, dans lequel une surface de sortie de lumière (44) de l'élément de réglage de distribution de lumière (4) est une surface rugueuse.

4. Dispositif électroluminescent selon l'une quelconque des revendications 1 à 3, dans lequel une couche d'air est intercalée entre les éléments électroluminescents à l'état solide (2) et une surface intérieure de la partie de rétention (41).

5. Dispositif électroluminescent selon l'une quelconque des revendications 1 à 4, dans lequel la partie de rétention (41) est formée de telle manière qu'un gradient d'une forme en coupe transversale orthogonale à une grande direction de la partie de rétention (41) diminue vers n'importe lequel des axes de sortie de lumière (L) qui passent respectivement par des parties centrales des éléments électroluminescents à l'état solide (2).

6. Dispositif électroluminescent selon l'une quelconque des revendications 1 à 5, dans lequel une surface de sortie de lumière de l'élément de réglage de distribution de lumière (4) est pourvue d'une pluralité de lentilles convexes (46) dans une grande direction.

7. Dispositif électroluminescent selon l'une quelconque des revendications 1 à 5, dans lequel une surface de sortie de lumière de l'élément de réglage de distribution de lumière (4) est pourvue d'une pluralité de lentilles concaves (47) dans une grande direction.

8. Dispositif électroluminescent selon l'une quelconque des revendications 1 à 7, dans lequel l'élément de conversion de longueur d'onde (92) présente une forme circulaire en vue de dessus.

9. Dispositif électroluminescent selon l'une quelconque des revendications 1 à 7, dans lequel l'élément de conversion de longueur d'onde (92) présente une forme elliptique le long de la grande direction de l'élément de réglage de distribution de lumière en vue de dessus.

10. Dispositif électroluminescent selon l'une quelconque des revendications 1 à 9, dans lequel l'élément de conversion de longueur d'onde (92) est formé en appliquant une résine contenant un élément fluorescent sur la résine transparente ou en fixant une feuille fluorescente sur la résine transparente.

11. Dispositif électroluminescent selon l'une quelconque des revendications 1 à 10, dans lequel :
les éléments électroluminescents à l'état solide (2) sont agencés de façon linéaire ; et
l'élément de réglage de distribution de lumière (4) est configuré de façon linéaire.

12. Dispositif électroluminescent selon l'une quelconque des revendications 1 à 10, dans lequel :
les éléments électroluminescents à l'état solide (2) sont agencés de façon annulaire ; et
l'élément de réglage de distribution de lumière (4) est formé de façon annulaire.

13. Dispositif d'éclairage (10) utilisant le dispositif électroluminescent (1) selon l'une quelconque des revendications 1 à 12.
